# EUROPEAN PATENT APPLICATION

(11) **EP 4 195 244 A1**
(43) Date of publication of application: **14.06.2023**
(21) Application number: 22206244.0
(22) Date of filing: 08.11.2022
(51) Int. Cl.: H01L 21/768, H01L 23/29, H01L 23/31

(54) **OXIDE AND CARBON LAYERS AT A SURFACE OF A SUBSTRATE FOR HYBRID BONDING**

(30) Priority: 10.12.2021 US 202117547745
(71) Applicant: INTEL Corporation, Santa Clara, CA 95054 (US)
(72) Inventor: CHANDHOK, Manish, Beaverton, OR 97006 (US); MUELLER, Brennen, Portland, OR 97229 (US); BIELEFELD, Jeffery, Forest Grove, OR 97116 (US); KABIR, Nafees A., Hillsboro, OR 97123 (US); VREELAND, Richard, Beaverton, OR 97006 (US)
(74) Representative: HGF

(57) **Abstract**

Embodiments herein relate to systems, apparatuses, or processes for hybrid bonding two dies, where at least one of the dies has a top layer to be hybrid bonded including one or more copper pad and a top oxide layer surrounding the one or more copper pad, with another layer beneath the oxide layer that includes carbon atoms. The top oxide layer and the other carbide layer beneath may form a combination gradient layer that goes from a top of the top layer that is primarily an oxide to a bottom of the other layer that is primarily a carbide. The top oxide layer may be formed by exposing the carbide layer to a plasma treatment. Other embodiments may be described and/or claimed.

## Description

### FIELD

Embodiments of the present disclosure generally relate to the field of package assemblies, and in particular to package assemblies that include hybrid bonded dies or wafers.

### BACKGROUND

Continued reduction in the size of mobile electronic devices, such as smart phones and ultrabooks, is a driving force for reducing package sizes and increasing the quality of components within packages.

### BRIEF DESCRIPTION OF THE DRAWINGS

FIG. 1 shows a perspective view of a die that includes an oxide and a carbon layer at a surface of the die in preparation for hybrid bonding, in accordance with various embodiments.
FIGs. 2A-2C shows cross section side views of a legacy implementation of a die prior to and subsequent to hybrid bonding.
FIG. 3 shows a cross section side view of two dies that are hybrid bonded with respective copper pads that are misaligned, in accordance with various embodiments.
FIGs. 4A-4E show various stages of a manufacturing process for creating a die that includes an oxide layer and a carbon layer at a surface of the die for hybrid bonding, in accordance with various embodiments.
FIG. 5 shows an example of a package that includes a plurality of stacked dies, each with an oxide and a carbon layer at a surface of both sides of a die, that are hybrid bonded, in accordance with various embodiments.
FIGs. 6A-6B schematically illustrate a top view of an example die in wafer form and in singulated form, and a cross section side view of a package assembly, in accordance with various embodiments.
FIG. 7 illustrates an example of a process for creating a die or a wafer that includes an oxide and a carbon layer at a surface of the die in preparation for hybrid bonding, in accordance with various embodiments.
FIG. 8 schematically illustrates a computing device, in accordance with embodiments.

### DETAILED DESCRIPTION

Embodiments of the present disclosure may generally relate to systems, apparatus, techniques, and/or processes directed to performing hybrid bonding between two dies, between a wafer and a die, or between two wafers. In embodiments, a top layer of a die to be hybrid bonded to another die includes one or more copper pads and a top oxide layer surrounding the one or more copper pads, with another layer beneath the oxide layer that includes carbon atoms. In embodiments, the top layer and the other layer beneath may be a combination gradient layer that goes from a top of the top layer that is primarily an oxide to a bottom of the other layer that is primarily a carbide. In embodiments, during manufacturing the top layer and the other layer beneath may be formed from a plasma induced dielectric gradient to facilitate hybrid bonding.

In legacy implementations, most dies, for example central processing units (CPU), are monolithic and formed out of a single piece of silicon. In these legacy implementations, all components of the CPU are embedded within the CPU chip, for example but not limited to regions of dynamic random-access memory (DRAM), cores of the CPU, etc. Legacy process technology has begun to move towards heterogeneous implementations, where a base chip is manufactured, and various chiplets are attached on the top of the base chip. These various chiplets may have different components, such as DRAM, CPU cores, etc. These heterogeneous implementations may allow a CPU package to be tailored for use within a server and to have a different component architecture than a CPU package tailored for use in an end-user, low-power laptop. The result of heterogeneous implementations have both yield and cost advantages over monolithic dies.

With these legacy implementations, the chiplets are bonded to a base chip through an interface layer that uses solder bumps, or something similar, for electrical coupling. The solder bumps require highly accurate pitch alignments between the base chip and the chiplets. As a result, legacy implementations began to move toward shrinking the pitch within the interface layer and increasing the density of the electrical connections by using direct bonding techniques. Direct bonding techniques no longer require solder bumps, therefore the pitch of the electrical connections may be smaller without risking solder bumps flow creating electrical shorts in the interface.

One of the direct bonding techniques adopted in legacy implementations is hybrid bonding. Hybrid bonding bonds two dies together by bonding both dielectric surfaces to each other and metal surfaces such as copper surfaces to each other. For example, during hybrid bonding, a surface of the base chip and a surface of the chiplet are placed into direct physical contact. As a result, a covalent bond is formed between the dielectric on the base chip and the dielectric on the chiplet as the two oxide layers fuse. During an annealing process, the metal surfaces also fuse and create an electrical connection across the metals. Thus, bond strength of the dies comes both through the metal bond and the dielectric bond.

During legacy hybrid bonding implementations, metal pads are surrounded with an oxide, which may also be referred to as a silicon-based dielectric, at a surface of a die. During high temperature annealing, for example as performed during back-end-of-line (BEOL) processing, copper in the metal pads may leak into the oxide. If the pitch between the metal pads is small, this may result in an electrical short between the metal pads during manufacture or subsequently during operation.

In embodiments, a carbide material is placed at the hybrid bonding interface surrounding the metal pads, and then part of the carbide material is converted to an oxide at the die surface using a plasma treatment prior to hybrid bonding. In embodiments, this results in a gradient within the carbide material, with more oxide at the surface where the carbon has been depleted, and more carbon away from the surface where the plasma treatment does not reach. In embodiments, the carbide will act as a copper diffusion barrier and the surface oxide will facilitate oxide to oxide bonding during hybrid bonding. In embodiments, the carbide may also act as a polish stop during manufacture due to its increased hardness relative to traditional etch stops such as silicon nitride. With these embodiments, during manufacture the carbide provides a higher quality metal to metal connection with less metal diffusion, and the oxide provides benefits of a strong oxide to oxide bond between metal pads. These embodiments may be incorporated into existing manufacturing techniques.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

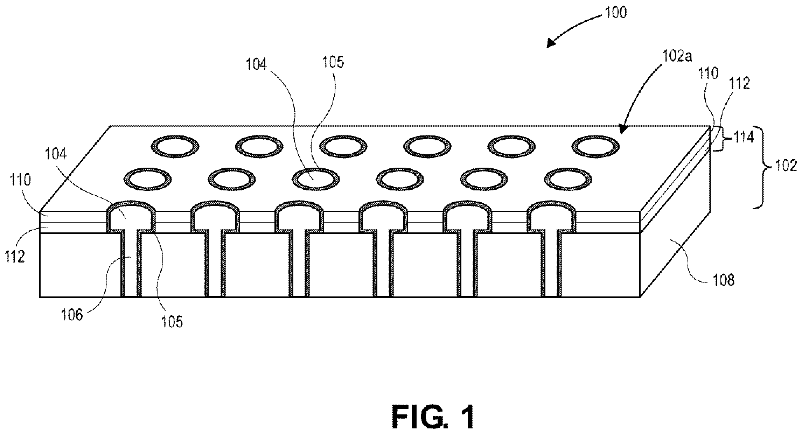

FIG. 1 shows a perspective view of a die that includes an oxide and a carbon layer at a surface of the die in preparation for hybrid bonding, in accordance with various embodiments. Die 100 includes a substrate 102 and a plurality of metal pads 104 at a surface of the substrate 102. The metal pads 104, which may be copper, may be electrically routed within the substrate 102 through electrical routings 106. In embodiments, these electrical routings 106 may include traces within various layers of the substrate 102 (not shown), or may include through silicon vias (TSV) that are filled with copper and extend through the various layers of the substrate 102.

The substrate 102 may include a dielectric 108. The dielectric 108 may be a silicon oxide material or some other suitable dielectric material. At a top of the substrate 102 there may be a first layer 110, and a second layer 112 beneath first layer 110. Together, the first layer 110 and the second layer 112 may form a gradient layer 114. In embodiments, the metal pads 104 may be surrounded by the first layer 110 and the second layer 112. The first layer 110 may also be referred to as an oxide layer or a low carbon layer. In embodiments, the first layer 110 may include silicon and oxygen.

The second layer 112 may be referred to as a carbon layer, and may include silicon and carbon. In embodiments, the second layer 112 may also include oxygen and/or nitrogen in addition to carbon. In embodiments, a protective layer 105 may surround the metal pads 104 and/or the electrical routings 106. This protective layer 105 may prevent diffusion of metal, for example copper, within the metal pads 104 or the electrical routings 106 from diffusing into the dielectric 108, the first layer 110, and/or the second layer 112. In embodiments, this protective layer 105 may include tantalum or tantalum alloys.

In embodiments, the first layer 110 may be formed when the gradient layer 114, which initially includes silicon and carbon including, but not limited to, SiC, SiCN, and/or SiOCN, is subjected to a plasma treatment. In embodiments, the plasma treatment may be applied, on a surface 102a of the substrate 102. This plasma treatment depletes the carbon atoms at the surface of the gradient layer 114 and forms the first layer 110. As a result, the carbon in the first layer 110 may change from SiC into SiOx, and through carbon depletion cause the first layer 110 to form into an oxide layer. This oxide layer 110 may be used to provide a strong bonding to another oxide layer (not shown) when the substrate 102 is hybrid bonded to another substrate (not shown) at substrate surface 102, as discussed below.

In embodiments, as the first layer 110 is created, the second layer 112 is formed based upon the depth of the formed first layer 110 that extends into the gradient layer 114. In embodiments, the first layer 110 may have a thickness ranging from a monolayer to 50 nm. In some embodiments, a thicker first layer 110 oxide may be desirable so that, subsequent to hybrid bonding, any water that may be created as a byproduct of a reaction occurring between dielectrics at the hybrid bonding interface may be absorbed by the oxide within the first layer 110 and not spread to the metal pads 104 or the second layer 112 carbide elements.

In embodiments, a selection of the plasma chemistry and approach of the plasma treatment may be chosen depending on what features on the substrate 102 are exposed. For example, oxidizing copper on the metal pads 104 may not be desirable, due to the increased resulting resistivity of the metal. This is particularly an issue for interconnects. In embodiments, other plasma parameters such as bias voltage, power of the radiofrequency (RF) generator, and other RF conditions, may use to adjust a depth of penetration, and therefore a depth of the first layer 110. These plasma parameters may also be adjusted to alter the effect of the plasma treatment on the metal pads 104. In embodiments, a cap on the metal pad 104, such as a layer of material, prior to plasma treatment may be used.

A thickness of the second layer 112, which may be referred to as the SiC or carbon layer, may be chosen based upon the performance characteristics required for the die 100. For example, smaller pitches between the metal pads 104, or smaller signal traces that have a higher density, may call for a thicker second layer 112 that includes more carbon atoms to increase die performance where the metal pads 104 may be subjected to higher voltage or amperage conditions. In addition to increased die performance, improved device stability, durability, and length of service may also be improved. When a thinner first layer 110 is used, there may be a decreased dielectric-to-dielectric bonding strength created during the hybrid bonding process. In embodiments, there may not be an identifiable plane or boundary between the first layer 110 and the second layer 112. Instead, in embodiments the two layers may be distinguished based upon a difference in overall concentration of carbon atoms per unit of volume.

One result of using SiC in the second layer 112 is that during manufacture of the die 100, SiC may facilitate chemical-mechanical polishing (CMP) as a stop layer. An additional result of using SiC is that it may passivate the top surface of the substrate 102 after bonding to provide a copper diffusion barrier. This passivation may be particularly important when the metal pads 104 are misaligned with other metal pads (not shown) during hybrid bonding, as discussed further below. Without SiC, the copper of the metal pads 104 may be in direct contact with oxide in dielectric 108, which does not serve as a good copper diffusion barrier and as a result may allow copper to leach into the surrounding oxide, eroding the metal pads 104 as discussed above.

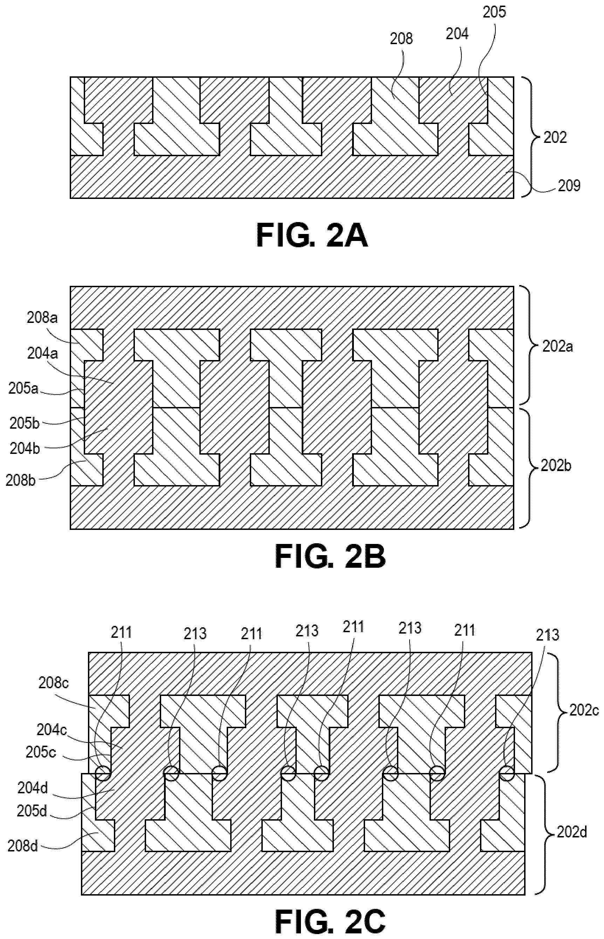

FIGs. 2A-2C shows cross section side views of a legacy implementation of a die prior to and subsequent to hybrid bonding. FIG. 2A shows a cross section side view of a legacy substrate 202 that includes a plurality of metal pads 204 surrounded by a protective barrier 205 that are within a dielectric 208. These legacy components may be similar to various components of substrate 101, metal pads 104, protective barrier 105, and dielectric 108 of FIG. 1. In legacy implementations, the metal pads 204 may connect to a bottom conductive layer 209, which may include electrical routing layers of one or more other electrical features. In implementations, the substrate 202 may be part of a legacy die or part of a legacy wafer.

FIG. 2B shows a cross section side view of a legacy substrate 202a and a legacy substrate 202b that are hybrid bonded. In this legacy implementation, the metal pads 204a, 204b are accurately aligned and are physically coupled during the hybrid bonding process. In addition, due to the accuracy of the alignment, protective barrier 205a is physically coupled with protective barrier 205b, and dielectric layers 208a and 208b are physically coupled with each other.

As shown in FIG. 2B, the metal pad 204a does not come into direct contact with the dielectric layer 208b, and the metal pad 204b does not come into direct contact with the dielectric layer 208a. In this way, a robust, higher-quality package may result with little copper diffusion during manufacturing and/or during operation overtime. However, in practical applications such accurate alignment may not be regularly achieved during the manufacturing process.

FIG. 2C shows an example legacy implementation of a misalignment. Legacy substrate 202c and a legacy substrate 202d that are hybrid bonded. In this legacy implementation, the metal pads 204c, 204d are partially physically coupled but not accurately aligned during the hybrid bonding process. As a result, protective barrier 205c is not physically coupled with protective barrier 205d. Instead, at location 211, dielectric layer 208c is in partial physical contact with metal pad 204d, and at location 213, dielectric layer 208d is in partial physical contact with metal pad 204c.

As a result, during the hybrid bonding process and/or during operation, particularly when high temperature anneals are involved, parts of the metal pads 204c, 204d, in particular copper, may diffuse into dielectric layers 208d, 208c respectively. In addition to weakening the electrical contact between metal pads 204c, 204d and/or causing an increase in resistivity, in extreme examples the diffused copper may cause an unintended electrical coupling between adjacent metal pads 204c, 204d resulting in an electrical short. A worse alignment means increased copper migration.

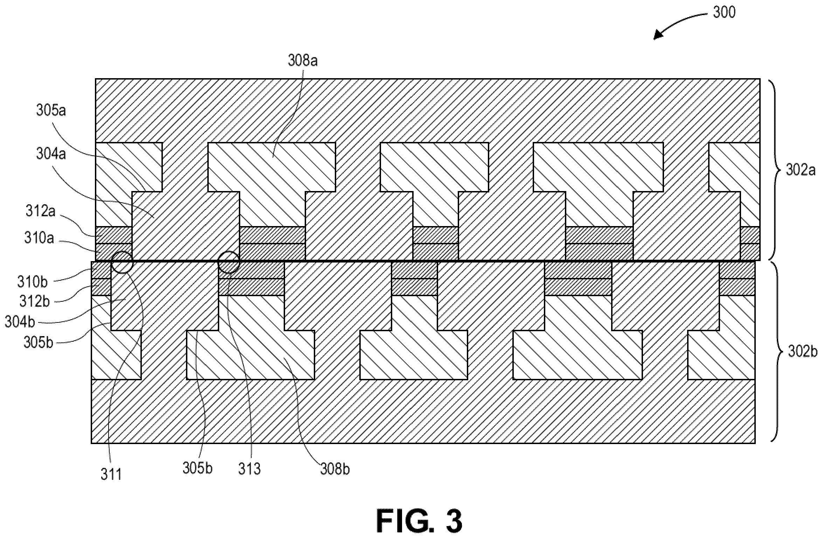

FIG. 3 shows a cross section side view of two dies that are hybrid bonded with respective copper pads that are misaligned, in accordance with various embodiments. Package portion 300 shows a first portion of a wafer or a die 302a that is hybrid bonded to a second portion of another wafer or a die 302b. In embodiments, the portion of the wafer or the die 302a, 302b may be similar to substrate 102 of FIG. 1. The surface of the first portion 302a and 302b include, respectively, first layer310a, 310b and second layer312a, 312b, with dielectric layers 308a, 308b below. As shown, metal pads 304a, 304b, which may include copper, are not aligned, and overlap each other at locations 311, 313, which may be similar to locations 211, 213 of FIG. 2C. In embodiments, both the first portion of the wafer or the die 302a and the second portion of another wafer or die 302b may be both in 300 mil, where one of the dies is flipped and the hybrid bonding attach process is performed.

However, due to the existence of the first layers 310a, 310b and/or the second layers 312a, 312b, the metal in the metal pads 304a does not come into contact with the dielectric layer 308b, and the metal in the metal pads 304b does not come into contact with the dielectric layer 308a. Thus, during manufacture, metal diffusion, such as copper diffusion, of the metal pads 304a 304b does not occur, or occurs at a much lower rate, than in legacy implementations as discussed with respect to FIG. 2C above.

In embodiments, although the first layers 310a, 310b may be oxide layers, with depleted numbers of carbon atoms, which may absorb some copper during diffusion at high manufacture processing or subsequent operating temperatures, the second layers 312a, 312b that include carbon will act as a protective barrier, similar to the protective barrier 305a, 305b that surround the metal pads 304a, 304b and reduce copper diffusion into the dielectric layers 308a, 308b.

A thickness of the first layers 310a, 310b, that are oxide layers with depleted carbon, may be selected based on a number of different factors, and the hybrid bonding process, in particular the plasma treatment, may be adjusted. For example, if a stronger hybrid bond surrounding the metal pads 304a, 304b is required, a thicker first layer 310a, 310b may be used, where the plasma treatment may be applied for a longer duration. In addition, if during the hybrid bonding process water is created, a thicker first layer 310a, 310b may be selected to absorb some of the water created. In embodiments, a larger thickness of the second layers 312a, 312b may be chosen to reduce copper diffusion rates out of the metal pads 304a, 304b, particularly when elevated temperatures are used during manufacturing.

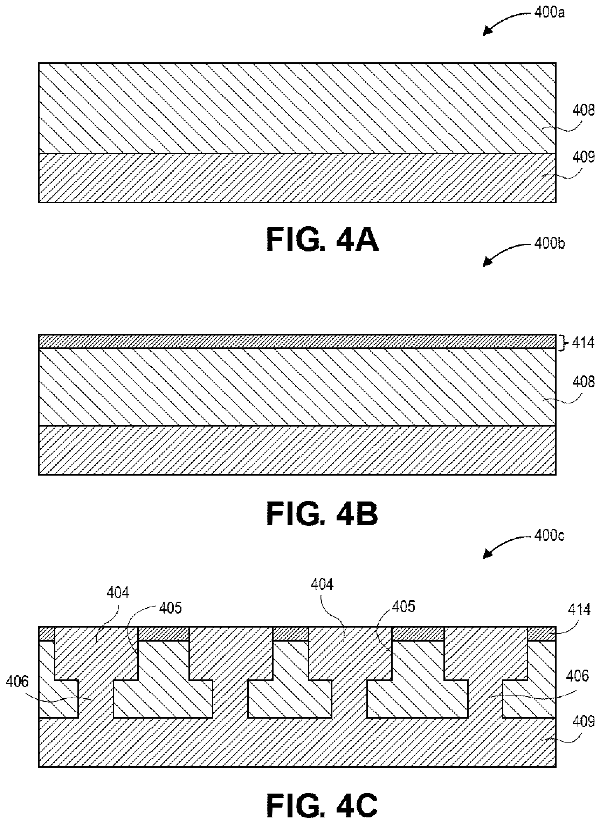

FIGs. 4A-4E show various stages of a manufacturing process for creating a die that includes an oxide layer and a carbon layer at a surface of the die for hybrid bonding, in accordance with various embodiments. FIG. 4A shows a stage in the manufacturing process of a wafer 400a, which may also be a die and/or a chiplet, where a dielectric layer 408 is placed on an electrical routing layer 409. In embodiments, the dielectric layer 408 may be an oxide, such as a silicon and oxide layer. In embodiments, the electrical routing layer 409 may be a metal layer, or may be a group of metal layers within one or more sublayers that may be used to route power and/or signal within the wafer 400a. Note that other features and/or functions that may be within the wafer 400a are not shown for clarity.

FIG. 4B shows a stage in the manufacturing process, where a gradient layer 414 is placed on the dielectric layer 408 of the wafer 400b. In embodiments, the gradient layer 414 may be similar to second layer 112 of FIG. 1, where the gradient layer 414 is initially a carbide layer that may include SiC, SiCN, and/or SiOCN. Gradient layer 414 will subsequently be partially converted into an oxide layer as described further below.

FIG. 4C shows a stage in the manufacturing process where a pad 404 and an electrical connection 406, which may be similar to pad 104 and electrical routings 106 of FIG. 1, is formed within a top side of the wafer 400c. This stage may be performed by a number of techniques known in the art, including a Damascene metallization process. In embodiments, the electrical connections 406 may electrically couple with the electrical routing layer 409. In embodiments, a protective layer 405 may be included on at least a portion of the surface of pads 404.

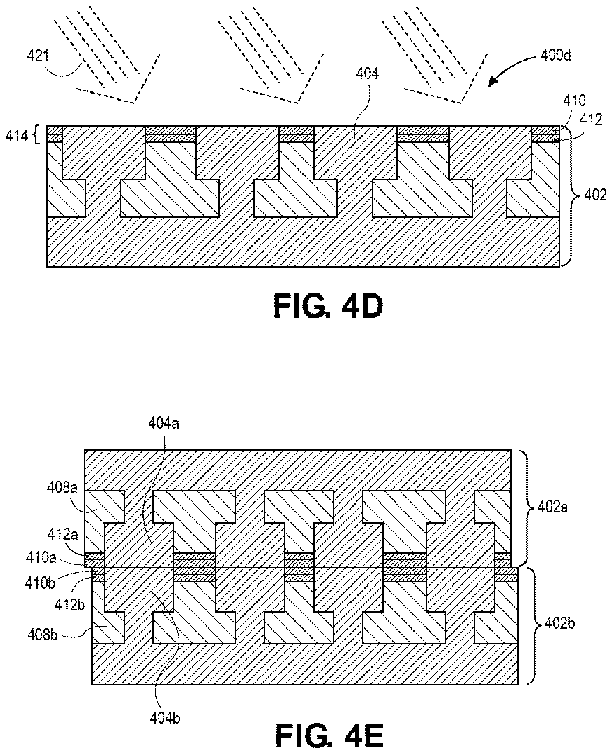

FIG. 4D shows a stage in the manufacturing process where a plasma treatment 421 is applied to the top surface of the gradient layer 414 in order to form the first layer 410, which may be similar to the first layer 110 of FIG. 1. The first layer 410 will be formed as the plasma treatment 421 depletes carbon atoms within the first layer 410 to form an oxide layer. The second layer 412, which may be similar to second layer 112 of FIG. 1, is what remains from the gradient layer 414. As discussed above, the first layer 410 and the second layer 412 may not be discreet layers, but rather may form a gradient in which the density of carbon atoms near the surface of the wafer 400d within the first layer 410 is less than the density of carbon atoms within a bottom of the second layer 412.

Depending upon the parameters of the plasma treatment, the surface of the copper pads 404 may not be affected by the plasma treatment. In embodiments, if the copper pads 404 have not been affected, then the copper would not be degraded and as a result inter-pad capacitance will be less of an issue during operation. In addition, using a carbon-based layer within layer 412, with a higher-k film, will also reduce inter-pad capacitance. In some embodiments, a temporary protective patterned layer (not shown) may be placed over the pads 404 prior to the plasma treatment, and then subsequently removed. As shown, substrate 402 is part of the wafer 400d.

FIG. 4E shows a stage in the manufacturing process where a portion of the first wafer 402a is bonded using a hybrid bonding process to a portion of a second wafer 402b. First wafer 402a and second wafer 402b may be similar to first wafer portion 302a and second wafer portion 302b of FIG. 3. The oxide first layer 410a will hybrid bond to the oxide first layer 410b, and the metal pad 404a will hybrid bond to the metal pad 404b. The carbon second layer 412a will be used to reduce diffusion from metal, such as copper, in metal pad 404b into dielectric 408a, and the carbon second layer 412b will be used to reduce diffusion from metal in metal pad 404a into dielectric 408b during manufacturing and/or during operation.

It should be noted that the selection of the composition of the oxide first layer 410a, 410b, the carbonic second layer 412a, 412b, and the dielectric 408a, 408b may be selected and/or varied within the wafer to address wafer bow, or to correct for wafer bow. In embodiments, changes within the plasma treatment may also be used to adjust wafer bow during the conversion of SiC to SiOx within the first layer 410a, 410b. In embodiments, if there is a compressive bow to the wafer, a type of dielectric may be chosen with a tensive bow. Likewise, if there is a tensive bow to the wafer, a type of dielectric may be chosen with a compressive bow.

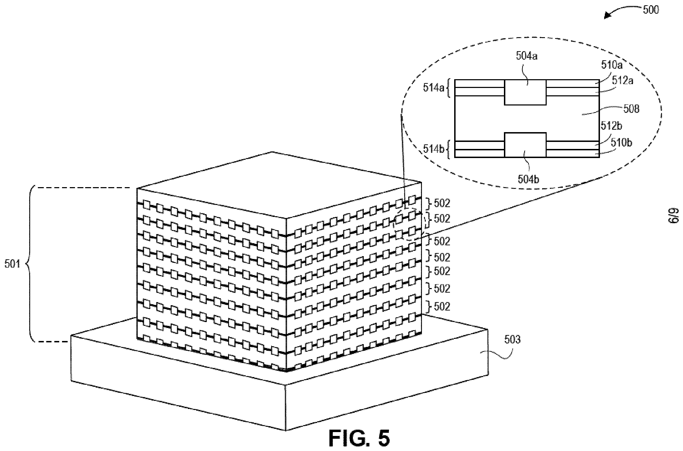

FIG. 5 shows an example of a package that includes a plurality of stacked dies, each with an oxide and a carbon layer at a surface of both sides of a die, that are hybrid bonded, in accordance with various embodiments. Package 500 includes a substrate 503 onto which a die stack 501 is electrically and physically coupled. The die stack 501 includes a plurality of dies 502, which may be similar to wafer 102 of FIG. 1, where the plurality of dies 502 are hybrid bonded together. The dies 502 may include a first pad 504a at a top of the dies 502 intersecting a first gradient area 514a, and a second pad 504b at a bottom of the dies 502 intersecting a second gradient area 514b, where gradient areas 514a, 514b may be similar to gradient area 114 of FIG. 1. The first pad 504a may be surrounded by a first layer 510a that is an oxide layer formed by the techniques described herein, and is on top of a second layer 512a that is a carbide layer, where the first layer 510a and the second layer 512a may be similar to the first layer 110 and second layer 112 of FIG. 1.

A second pad 504b may be surrounded by a first layer 510b that is an oxide layer formed by the techniques described herein, and beneath a second layer 512b that is a carbide layer. A dielectric material 508 may be between the first pad 504a and the second pad 504b. After hybrid bonding, any metal, such as copper, in the first pad 504a or the second pad 504b will not defuse, or may be less likely to diffuse into the dielectric material 508 due to the barrier properties of the carbide within the second layers 512a, 512b. The first layers 510a, 510b that include oxides (with depleted carbon atoms), will form a strong bond during the hybrid bonding process.

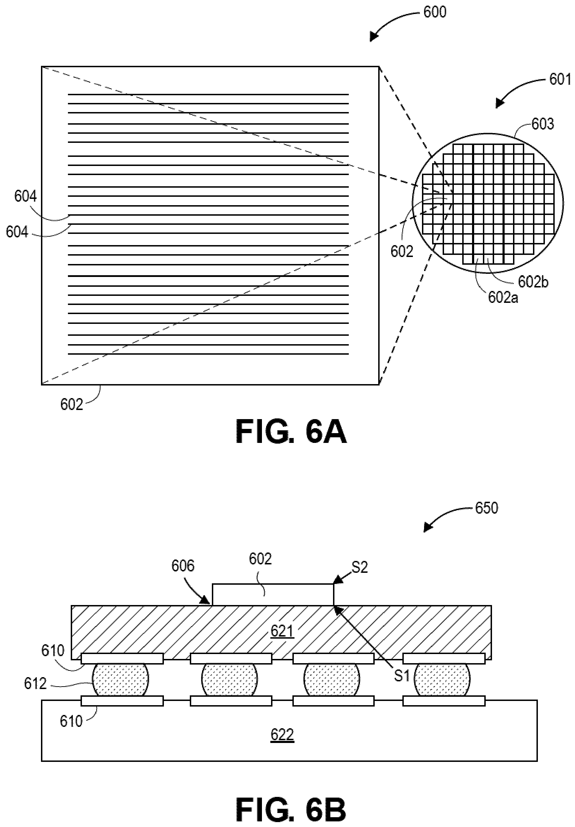

FIGs. 6A-6B schematically illustrate a top view of an example die in wafer form and in singulated form, and a cross section side view of a package assembly, in accordance with various embodiments. FIG. 6A schematically illustrates a top view of an example die 602 in a wafer form 601 and in a singulated form 600, in accordance with some embodiments. In some embodiments, die 602 may be one of a plurality of dies, e.g., dies 602, 602a, 602b, of a wafer 603 comprising semiconductor material, e.g., silicon or other suitable material. The plurality of dies, e.g., dies 602, 602a, 602b, may be formed on a surface of wafer 603. Each of the dies 602, 602a, 602b, may be a repeating unit of a semiconductor product that includes devices as described herein. For example, die 602 may include circuitry having transistor elements such as, for example, one or more channel bodies 604 (e.g., fin structures, nanowires, and the like) that provide a channel pathway for mobile charge carriers in transistor devices. Although one or more channel bodies 604 are depicted in rows that traverse a substantial portion of die 602, it is to be understood that one or more channel bodies 604 may be configured in any of a wide variety of other suitable arrangements on die 602 in other embodiments.

After a fabrication process of the device embodied in the dies is complete, wafer 603 may undergo a singulation process in which each of dies, e.g., die 602, is separated from one another to provide discrete "chips" of the semiconductor product. Wafer 603 may be any of a variety of sizes. In some embodiments, wafer 603 has a diameter ranging from about 25.4 mm to about 450 mm. Wafer 603 may include other sizes and/or other shapes in other embodiments. According to various embodiments, the one or more channel bodies 604 may be disposed on a semiconductor substrate in wafer form 601 or singulated form 600. One or more channel bodies 604 described herein may be incorporated in die 602 for logic, memory, or combinations thereof. In some embodiments, one or more channel bodies 604 may be part of a system-on-chip (SoC) assembly.

FIG. 6B schematically illustrates a cross-section side view of an integrated circuit (IC) assembly 650, in accordance with some embodiments. In some embodiments, IC assembly 650 may include one or more dies, e.g., die 602, hybrid bonded using techniques described herein to package substrate 621. Die 602 may include one or more channel bodies 604 that serve as channel bodies of multi-threshold voltage transistor devices. In some embodiments, package substrate 621 may be electrically coupled with a circuit board 622 as is well known to a person of ordinary skill in the art. Die 602 may represent a discrete product made from a semiconductor material (e.g., silicon) using semiconductor fabrication techniques such as thin film deposition, lithography, etching, and the like used in connection with forming Complementary Metal Oxide Semiconductor (CMOS) devices. In some embodiments, die 602 may be, include, or be a part of a processor, memory, SoC or ASIC in some embodiments.

Die 602 can be attached to package substrate 621 according to a wide variety of suitable configurations including, for example, being directly coupled with package substrate 621 in a flip-chip configuration, as depicted. In the flip-chip configuration, an active side S1 of die 602 including circuitry is attached to a surface of package substrate 621 using hybrid bonding structures as described herein that may also electrically couple die 602 with package substrate 621. Active side S1 of die 602 may include multi-threshold voltage transistor devices as described herein. An inactive side S2 of die 602 may be disposed opposite to active side S1.

In some embodiments, package substrate 621 is an epoxy-based laminate substrate having a core and/or build-up layers such as, for example, an Ajinomoto Build-up Film (ABF) substrate. Package substrate 621 may include other suitable types of substrates in other embodiments including, for example, substrates formed from glass, ceramic, or semiconductor materials.

Package substrate 621 may include electrical routing features configured to route electrical signals to or from die 602. The electrical routing features may include pads or traces (not shown) disposed on one or more surfaces of package substrate 621 and/or internal routing features (not shown) such as trenches, vias, or other interconnect structures to route electrical signals through package substrate 621. In some embodiments, package substrate 621 may include electrical routing features such as pads (not shown) configured to receive the respective die-level interconnect structures 606 of die 602.

Circuit board 622 may be a printed circuit board (PCB) comprising an electrically insulative material such as an epoxy laminate. Circuit board 622 may include electrically insulating layers composed of materials such as, for example, polytetrafluoroethylene, phenolic cotton paper materials such as Flame Retardant 4 (FR-4), FR-1, cotton paper and epoxy materials such as CEM-1 or CEM-3, or woven glass materials that are laminated together using an epoxy resin prepreg material. Interconnect structures such as traces, trenches, vias may be formed through the electrically insulating layers to route the electrical signals of die 602 through circuit board 622. Circuit board 622 may comprise other suitable materials in other embodiments. In some embodiments, circuit board 622 is a motherboard as is well known to a person of ordinary skill in the art.

Package-level interconnects such as, for example, solder balls 612 may be coupled to one or more pads 610 on package substrate 621 and/or on circuit board 622 to form corresponding solder joints that are configured to further route the electrical signals between package substrate 621 and circuit board 622. Pads 610 may comprise any suitable electrically conductive material such as metal including, for example, nickel (Ni), palladium (Pd), gold (Au), silver (Ag), copper (Cu), and combinations thereof. Other suitable techniques to physically and/or electrically couple package substrate 621 with circuit board 622 may be used in other embodiments.

IC assembly 650 may include a wide variety of other suitable configurations in other embodiments including, for example, suitable combinations of flip-chip and/or wire-bonding configurations, interposers, multi-chip package configurations including system-in-package (SiP), and/or package-on-package (PoP) configurations. Other suitable techniques to route electrical signals between die 602 and other components of IC assembly 650 may be used in some embodiments.

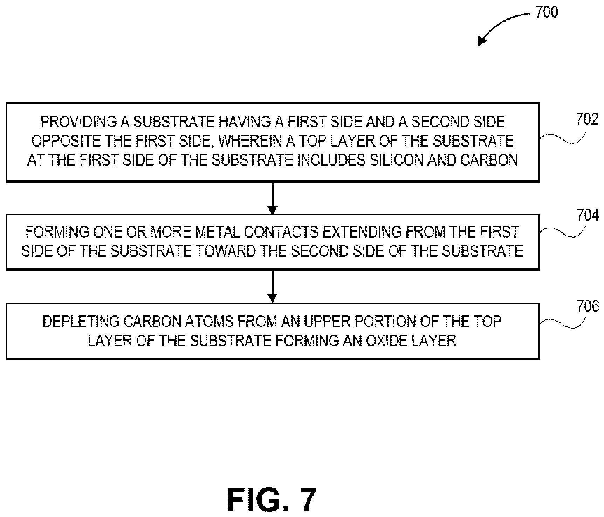

FIG. 7 illustrates an example of a process for creating a die or a wafer that includes an oxide and a carbon layer at a surface of the die in preparation for hybrid bonding, in accordance with various embodiments. Process 700 may be performed by one or more elements, techniques, or systems that may be described herein, and in particular with respect to FIGs. 1 and 3-6B.

At block 702, the process includes providing a substrate having a first side and a second side opposite the first side, wherein a top layer of the substrate at the first side of the substrate includes silicon and carbon. In embodiments, the substrate may be similar to layers 414, 408 of FIG. 4B.

At block 704, the process further includes forming one or more metal contacts extending from the first side of the substrate toward the second side of the substrate. In embodiments, the metal contacts may be similar to metal contacts 406 of FIG. 4C.

At block 706, the process further includes depleting carbon atoms from an upper portion of the top layer of the substrate forming an oxide layer. In embodiments, the upper portion of the top layer may be similar to first layer 410 of FIG. 4D.

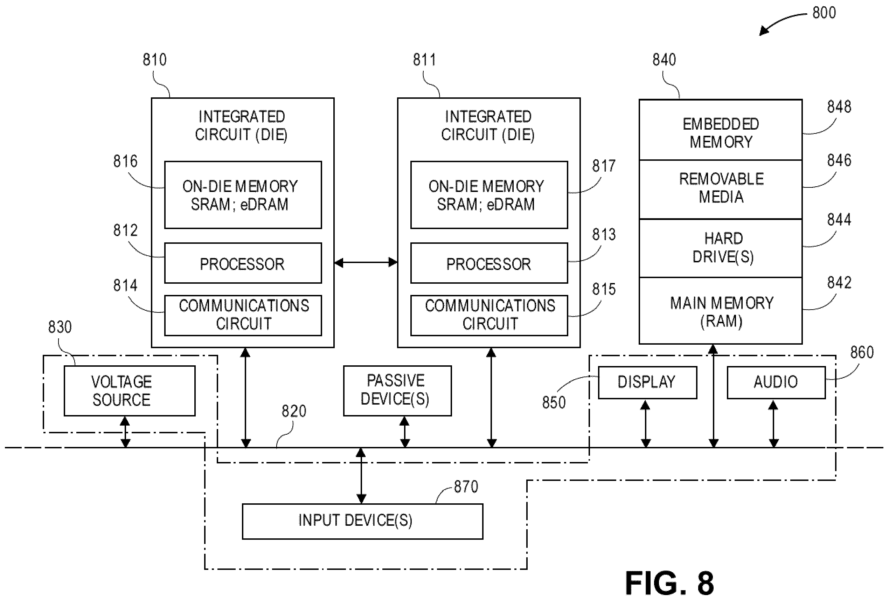

FIG. 8 schematically illustrates a computing device, in accordance with embodiments. FIG. 8 is a schematic of a computer system 800, in accordance with an embodiment of the present invention. The computer system 800 (also referred to as the electronic system 800) as depicted can embody oxide and carbon layers at a surface of a substrate for hybrid bonding, according to any of the several disclosed embodiments and their equivalents as set forth in this disclosure. The computer system 800 may be a mobile device such as a netbook computer. The computer system 800 may be a mobile device such as a wireless smart phone. The computer system 800 may be a desktop computer. The computer system 800 may be a hand-held reader. The computer system 800 may be a server system. The computer system 800 may be a supercomputer or high-performance computing system.

In an embodiment, the electronic system 800 is a computer system that includes a system bus 820 to electrically couple the various components of the electronic system 800. The system bus 820 is a single bus or any combination of busses according to various embodiments. The electronic system 800 includes a voltage source 830 that provides power to the integrated circuit 810. In some embodiments, the voltage source 830 supplies current to the integrated circuit 810 through the system bus 820.

The integrated circuit 810 is electrically coupled to the system bus 820 and includes any circuit, or combination of circuits according to an embodiment. In an embodiment, the integrated circuit 810 includes a processor 812 that can be of any type. As used herein, the processor 812 may mean any type of circuit such as, but not limited to, a microprocessor, a microcontroller, a graphics processor, a digital signal processor, or another processor. In an embodiment, the processor 812 includes, or is coupled with, oxide and carbon layers at a surface of a substrate for hybrid bonding, as disclosed herein. In an embodiment, SRAM embodiments are found in memory caches of the processor. Other types of circuits that can be included in the integrated circuit 810 are a custom circuit or an application-specific integrated circuit (ASIC), such as a communications circuit 814 for use in wireless devices such as cellular telephones, smart phones, pagers, portable computers, two-way radios, and similar electronic systems, or a communications circuit for servers. In an embodiment, the integrated circuit 810 includes on-die memory 816 such as static random-access memory (SRAM). In an embodiment, the integrated circuit 810 includes embedded on-die memory 816 such as embedded dynamic random-access memory (eDRAM).

In an embodiment, the integrated circuit 810 is complemented with a subsequent integrated circuit 811. Useful embodiments include a dual processor 813 and a dual communications circuit 815 and dual on-die memory 817 such as SRAM. In an embodiment, the dual integrated circuit 810 includes embedded on-die memory 817 such as eDRAM.

In an embodiment, the electronic system 800 also includes an external memory 840 that in turn may include one or more memory elements suitable to the particular application, such as a main memory 842 in the form of RAM, one or more hard drives 844, and/or one or more drives that handle removable media 846, such as diskettes, compact disks (CDs), digital variable disks (DVDs), flash memory drives, and other removable media known in the art. The external memory 840 may also be embedded memory 848 such as the first die in a die stack, according to an embodiment.

In an embodiment, the electronic system 800 also includes a display device 850, an audio output 860. In an embodiment, the electronic system 800 includes an input device such as a controller 870 that may be a keyboard, mouse, trackball, game controller, microphone, voice-recognition device, or any other input device that inputs information into the electronic system 800. In an embodiment, an input device 870 is a camera. In an embodiment, an input device 870 is a digital sound recorder. In an embodiment, an input device 870 is a camera and a digital sound recorder.

As shown herein, the integrated circuit 810 can be implemented in a number of different embodiments, including a package substrate having oxide and carbon layers at a surface of a substrate for hybrid bonding, according to any of the several disclosed embodiments and their equivalents, an electronic system, a computer system, one or more methods of fabricating an integrated circuit, and one or more methods of fabricating an electronic assembly that includes a package substrate having oxide and carbon layers at a surface of a substrate for hybrid bonding, according to any of the several disclosed embodiments as set forth herein in the various embodiments and their art-recognized equivalents. The elements, materials, geometries, dimensions, and sequence of operations can all be varied to suit particular I/O coupling requirements including array contact count, array contact configuration for a microelectronic die embedded in a processor mounting substrate according to any of the several disclosed package substrates having oxide and carbon layers at a surface of a substrate for hybrid bonding embodiments and their equivalents. A foundation substrate may be included, as represented by the dashed line of FIG. 8. Passive devices may also be included, as is also depicted in FIG. 8.

### EXAMPLES

The following paragraphs describe examples of various embodiments.

Example 1 is an apparatus comprising: a substrate having a first side and a second side opposite the first side, the substrate including: a first layer of the substrate at the first side of the substrate, wherein the first layer includes oxide; a second layer of the substrate below and in contact with the first layer of the substrate, wherein the second layer includes carbon; and a plurality of metal contacts extending from the first side of the substrate toward the second side of the substrate, wherein the plurality of metal contacts are surrounded by the first layer and the second layer.

Example 2 may include the apparatus of example 1, or of any other example or embodiment herein, wherein a density of carbon atoms in the first layer is less than a density of carbon atoms in the second layer.

Example 3 may include the apparatus of example 1, or of any other example or embodiment described herein, wherein the first layer includes silicon and oxygen, and wherein the second layer includes silicon and carbon.

Example 4 may include the apparatus of example 3, or of any other example or embodiment described herein, wherein the first layer ranges in thickness from 1 nm to 50 nm.

Example 5 may include the apparatus of example 3, or of any other example or embodiment described herein, wherein the second layer includes a selected one more of oxygen or nitrogen.

Example 6 may include the apparatus of example 1, or of any other example or embodiment described herein, wherein the plurality of metal contacts include copper.

Example 7 may include the apparatus of example 1, or of any other example or embodiment described herein, further comprising a third layer below and in contact with the second layer, wherein the third layer is a dielectric.

Example 8 may include the apparatus of example 1, or of any other example or embodiment described herein, further comprising a plurality of barriers, respectively, between the plurality of metal contacts and the substrate.

Example 9 may include the apparatus of example 8, or of any other example or embodiment described herein, wherein the plurality of barriers include a layer of tantalum.

Example 10 may include the apparatus of example 1, or of any other example or embodiment described herein, wherein the apparatus is a selected one of: a portion of a wafer or a portion of a die.

Example 11 may include the apparatus of example 1, or of any other example or embodiment described herein, further comprising: a third layer of the substrate at the second side of the substrate, wherein the third layer includes oxide; a fourth layer of the substrate in contact with the third layer of the substrate, wherein the fourth layer includes carbon; and another plurality of metal contacts extending from the second side of the substrate toward the first side of the substrate, wherein the other plurality of metal contacts are surrounded by the third layer and the fourth layer.

Example 12 may include the apparatus of example 1, or of any other example or embodiment described herein, wherein the substrate is a first substrate; and further comprising: a second substrate having a first side and a second side opposite the first side, the second substrate including: a first layer of the second substrate at the first side of the second substrate, wherein the first layer of the second substrate includes oxide; a second layer of the second substrate below and in contact with the first layer of the second substrate, wherein the second layer of the second substrate includes carbon; and a second plurality of metal contacts extending from the first side of the second substrate toward the second side of the second substrate, wherein the second plurality of metal contacts are surrounded by the first layer and the second layer; and wherein the plurality of metal contacts of the first substrate are directly physically and electrically coupled with the second plurality of metal contacts of the second substrate.

Example 13 may include the apparatus of example 12, or of any other example or embodiment described herein, wherein a portion of the plurality of metal contacts of the first substrate are in direct physical contact with the first layer or the second layer of the second substrate.

Example 14 is a method comprising: providing a substrate having a first side and a second side opposite the first side, wherein a top layer of the substrate at the first side of the substrate includes silicon and carbon; forming one or more metal contacts extending from the first side of the substrate toward the second side of the substrate; and depleting carbon atoms from an upper portion of the top layer of the substrate forming an oxide layer.

Example 15 may include the method of example 14, or of any other example or embodiment described herein, wherein the top layer of the substrate further includes a selected one or more of oxygen or nitrogen.

Example 16 may include the method of example 14, or of any other example or embodiment described herein, wherein depleting carbon atoms from the upper portion of the top layer of the substrate further includes applying a plasma treatment to the top layer of the substrate.

Example 17 may include the method of example 14, or of any other example or embodiment described herein, wherein a thickness of the upper portion of the top layer of the substrate is less than or equal to 10 nm.

Example 18 may include the method of example 14, or of any other example or embodiment described herein, wherein the substrate is a first substrate, and further comprising: providing a second substrate having a first side and a second side opposite the first side, wherein a top layer of the second substrate at the first side of the second substrate includes silicon and carbon; forming one or more metal contacts extending from the first side of the second substrate toward the second side of the second substrate; depleting carbon atoms from an upper portion of the top layer of the second substrate forming an oxide layer; and coupling the one or more metal contacts on the first side of the first substrate with the one or more metal contacts on the first side of the second substrate.

Example 19 may include the method of example 18, or of any other example or embodiment described herein, wherein coupling the one or more metal contacts on the first side of the first substrate with the one or more metal contacts on the first side of the second substrate further includes hybrid bonding.

Example 20 may include the method of example 18, or of any other example or embodiment described herein, wherein the metal contacts include copper.

Example 21 is a package comprising: a first die that includes a first substrate, wherein the first substrate includes: a first layer of the first substrate at the first side of the first substrate, wherein the first layer includes oxide; a second layer of the first substrate below and in contact with the first layer of the first substrate, wherein the second layer includes carbon; and a first plurality of metal contacts extending from the first side of the first substrate toward the second side of the first substrate, wherein the first plurality of metal contacts are surrounded by the first layer of the first substrate and the second layer of the first substrate; a second die that includes a second substrate, wherein the second substrate includes: a first layer of the second substrate at the first side of the second substrate, wherein the first layer includes oxide; a second layer of the second substrate below and in contact with the first layer of the second substrate, wherein the second layer includes carbon; and a second plurality of metal contacts extending from the first side of the second substrate toward the second side of the second substrate, wherein the second plurality of metal contacts are surrounded by the first layer and the second layer; and wherein the first plurality of metal contacts of the first die are coupled with the second plurality of metal contacts of the second die with hybrid bonding.

Example 22 may include the package of example 21, or of any other example or embodiment described herein, wherein the metal contacts include copper.

Example 23 may include the package of example 21, or of any other example or embodiment described herein, wherein a surface of one of the first plurality of metal contacts of the first substrate is in contact with the first layer of the second substrate or the second layer of the second substrate.

Example 24 may include the package of example 21, or of any other example or embodiment described herein, wherein a density of carbon atoms in the first layer of the first substrate is less than a density of carbon atoms in the second layer of the first substrate, and wherein a density of carbon atoms in the first layer of the second substrate is less than a density of carbon atoms in the second layer of the second substrate.

Example 25 may include the package of example 21, or of any other example or embodiment described herein, wherein a depth of the first layer of the first substrate or a depth of the first layer of the second substrate is less than 30 nm.

Example 26 includes an apparatus comprising: a substrate having a first side and a second side opposite the first side, the substrate including: a layer of the substrate at the first side of the substrate, wherein the layer includes a higher density of carbon atoms near to the first side of the substrate and a lower density of carbon atoms away from the first side of the substrate; and a plurality of metal contacts extending from the first side of the substrate toward the second side of the substrate, wherein the plurality of metal contacts are surrounded by the layer.

Example 27 may include the apparatus of example 26, or of any other example or embodiment described herein, wherein the layer includes one or more of: silicon, oxygen, nitrogen, and carbon.

Example 28 may include the apparatus of example 26, or of any other example or embodiment described herein, wherein the layer ranges in thickness from 1 nm to 50 nm.

Example 29 may include the apparatus of example 26, or of any other example or embodiment described herein, wherein the plurality of metal contacts include copper.

Example 30 may include the apparatus of example 26, or of any other example or embodiment described herein, further comprising another layer below and in contact with the layer, wherein the other layer includes a dielectric.

Example 31 may include the apparatus of example 26, or of any other example or embodiment described herein, further comprising a plurality of barriers that include tantalum, respectively, between the plurality of metal contacts and the substrate.

Example 32 may include the apparatus of example 26, or any of any other example or embodiment described herein, wherein the apparatus is a selected one of: a portion of a wafer or a portion of a die.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

The above description of illustrated embodiments, including what is described in the Abstract, is not intended to be exhaustive or to limit embodiments to the precise forms disclosed. While specific embodiments are described herein for illustrative purposes, various equivalent modifications are possible within the scope of the embodiments, as those skilled in the relevant art will recognize.

These modifications may be made to the embodiments in light of the above detailed description. The terms used in the following claims should not be construed to limit the embodiments to the specific implementations disclosed in the specification and the claims. Rather, the scope of the invention is to be determined entirely by the following claims, which are to be construed in accordance with established doctrines of claim interpretation.

## Claims

1. An apparatus comprising:
a substrate having a first side and a second side opposite the first side, the substrate including:
a first layer of the substrate at the first side of the substrate, wherein the first layer includes oxide;
a second layer of the substrate below and in contact with the first layer of the substrate, wherein the second layer includes carbon; and
a plurality of metal contacts extending from the first side of the substrate toward the second side of the substrate, wherein the plurality of metal contacts are surrounded by the first layer and the second layer.

2. The apparatus of claim 1, wherein a density of carbon atoms in the first layer is less than a density of carbon atoms in the second layer.

3. The apparatus of claim 1 or 2, wherein the first layer includes silicon and oxygen, and wherein the second layer includes silicon and carbon.

4. The apparatus of any of claims 1 to 3, wherein the first layer ranges in thickness from 1 nm to 50 nm.

5. The apparatus of any of claims 1 to 4, wherein the second layer includes a selected one more of oxygen or nitrogen.

6. The apparatus of any preceding claim, wherein the plurality of metal contacts include copper.

7. The apparatus of any preceding claim, further comprising a third layer below and in contact with the second layer, wherein the third layer is a dielectric.

8. The apparatus of any preceding claim, further comprising a plurality of barriers, respectively, between the plurality of metal contacts and the substrate.

9. The apparatus of claim 8, wherein the plurality of barriers include a layer of tantalum.

10. The apparatus of claim any preceding claim, wherein the apparatus is a selected one of: a portion of a wafer or a portion of a die.

11. The apparatus of claim any preceding claim, further comprising:
a third layer of the substrate at the second side of the substrate, wherein the third layer includes oxide;
a fourth layer of the substrate in contact with the third layer of the substrate, wherein the fourth layer includes carbon; and
another plurality of metal contacts extending from the second side of the substrate toward the first side of the substrate, wherein the other plurality of metal contacts are surrounded by the third layer and the fourth layer.

12. The apparatus of claim any preceding claim, wherein the substrate is a first substrate; and further comprising:
a second substrate having a first side and a second side opposite the first side, the second substrate including:
a first layer of the second substrate at the first side of the second substrate, wherein the first layer of the second substrate includes oxide;
a second layer of the second substrate below and in contact with the first layer of the second substrate, wherein the second layer of the second substrate includes carbon; and
a second plurality of metal contacts extending from the first side of the second substrate toward the second side of the second substrate, wherein the second plurality of metal contacts are surrounded by the first layer and the second layer; and
wherein the plurality of metal contacts of the first substrate are directly physically and electrically coupled with the second plurality of metal contacts of the second substrate.

13. A method comprising:
providing a substrate having a first side and a second side opposite the first side, wherein a top layer of the substrate at the first side of the substrate includes silicon and carbon;
forming one or more metal contacts extending from the first side of the substrate toward the second side of the substrate; and
depleting carbon atoms from an upper portion of the top layer of the substrate forming an oxide layer.

14. The method of claim 13, wherein the top layer of the substrate further includes a selected one or more of oxygen or nitrogen.

15. The method of claim 13 or 14, wherein depleting carbon atoms from the upper portion of the top layer of the substrate further includes applying a plasma treatment to the top layer of the substrate.
